# EUROPEAN PATENT APPLICATION

(11) **EP 3 595 150 A2**
(43) Date of publication of application: **15.01.2020**
(21) Application number: 19185706.9
(22) Date of filing: 11.07.2019
(51) Int. Cl.: H02M 1/084, H02M 1/32, H03K 17/14, H03K 17/08

(54) **POWER CONVERTING DEVICE, COMPRESSOR INCLUDING THE SAME, AND CONTROL METHOD THEREOF**

(30) Priority: 12.07.2018 KR 20180081117
(71) Applicant: LG ELECTRONICS INC., Yeongdeungpo-Gu Seoul 07336 (KR)
(72) Inventor: KIM, Kiman, 08592 Seoul (KR); KIM, Sanghyeon, 08592 Seoul (KR); KIM, Taekyoung, 08592 Seoul (KR); CHO, Yongsoo, 08592 Seoul (KR)
(74) Representative: Vossius & Partner Patentanwälte Rechtsanwälte mbB

(57) **Abstract**

The present invention relates to a power converting device, and more particularly, to a power converting device capable of protecting a compressor from overheat, a compressor including the same, and a control method thereof. The device includes an inverter for generating an alternate current for driving the motor using power supplied from a power supply, the inverter including a plurality of switching elements; a driver for driving the plurality of switching elements; a variable resistance unit disposed between and electrically coupled to the driver and a gate of each of the switching elements, wherein the variable resistance unit has a resistance value inversely proportional to a temperature of the inverter; and a controller configured for transferring a drive signal to the driver.

## Description

### BACKGROUND OF THE DISCLOSURE

### Field of the Disclosure

The present disclosure relates to a power converting device, and more particularly, to a power converting device capable of protecting a compressor from overheat, a compressor including the same, and a control method thereof.

### Discussion of the Related Art

Generally, a compressor uses a motor as a driving source. The motor is supplied with AC power from a power converting device.

The power converting device mainly includes an inverter. This power converting device generates AC power for driving the motor using an input power.

In general, the inverter includes a switching element implemented as a semiconductor element such as an insulated gate bipolar mode transistor (IGBT).

However, when the switching element is overheated by external temperature or overloading conditions, the function of protecting the switching element from such overheating may not be separately implemented.

Therefore, it is required to protect the switching element from overheating. In this case, it is required to make a product with the power converting device operate without a failure.

Further, it is required to design circuitry of the power converting device, with considering both noise generation and switching loss due to PWM operation of the switching element as a main component of the inverter.

### SUMMARY OF THE DISCLOSURE

A purpose of the present disclosure is to provide a power converting device capable of preventing damage of the switching element due to the inverter overheating, and thus, of extending a lifetime of the switching element, and to provide a compressor including the same, and a control method thereof.

Further, another purpose of the present disclosure is to provide a power converting device capable of improving EMC performance in a nominal operation period in an inverter operating temperature range, and to provide a compressor including the same, and a control method thereof.

Furthermore, still another purpose of the present disclosure is to provide a power converting device capable of monitoring the inverter temperature, and, accordingly, of implementing an additional operation according to the monitored temperature, and to provide a compressor including the same, and a control method thereof are provided.

In a first aspect of the present disclosure, there is provided a power converting device for driving a compressor motor, the device comprising: an inverter for generating an alternate current for driving the motor using power supplied from a power supply, the inverter including a plurality of switching elements; a driver for driving the plurality of switching elements; a variable resistance unit disposed between and electrically coupled to the driver and a gate of each of the switching elements, wherein the variable resistance unit has a resistance value varying based on a temperature of the inverter; and a controller configured for transferring a drive signal to the driver.

In one implementation of the first aspect, the variable resistance unit includes a thermistor having a resistance value inversely proportional to a temperature.

In one implementation of the first aspect, the variable resistance unit further includes a gate resistor connected in series or in parallel with the thermistor.

In one implementation of the first aspect, the controller is configured for: sensing a resistance value of the variable resistance unit; and controlling a switching operation of each of the switching elements based on the sensed resistance value of the variable resistance unit.

In one implementation of the first aspect, the controller is further configured for classifying an operation region of the inverter into a nominal operation region and an overheating operation region based on the resistance value of the variable resistance unit; and controlling a switching operation of each of the switching elements based on the nominal operation region or the overheating operation region.

In one implementation of the first aspect, the controller is further configured for controlling the switching operation of each of the switching elements in the overheating operation region such that each switching element operates in a discontinuous PWM (DPWN) scheme in which each switching element is disactivated during a predetermined period.

In one implementation of the first aspect, the controller is further configured for controlling the switching operation of each of the switching elements in the nominal operation region such that a conductive noise is reduced or electro-magnetic compatibility (EMC) performance is improved.

In one implementation of the first aspect, the controller is further configured for stopping an operation of the inverter when a temperature sensed from the variable resistance unit exceeds a temperature of the overheating operation region.

In one implementation of the first aspect, the controller is further configured for controlling the switching operation of each of the switching elements in the overheating operation region so as to reduce a switching loss of each of the switching elements.

In a second aspect of the present disclosure, there is provided a method for operating a power converting device, the device includes an inverter for generating an alternate current for driving the motor using power supplied from a power supply, wherein the inverter includes a plurality of switching elements driven by a driver, and a variable resistance unit disposed between and electrically coupled to the driver and a gate of each of the switching elements, wherein the variable resistance unit has a resistance value varying based on a temperature of the inverter, the method comprises: driving each switching element based on the resistance value of the variable resistance unit when a temperature of the inverter is equal to or lower than a first setting temperature; and driving each switching element so as to reduce a switching loss of the inverter when the temperature of the inverter exceeds the first setting temperature.

In one implementation of the second aspect, the method further comprises stopping an operation of the inverter when the temperature of the inverter exceeds a second setting temperature higher than the first setting temperature.

In one implementation of the second aspect, driving each switching element so as to reduce the switching loss of the inverter includes lowering a switching frequency of each switching element.

In one implementation of the second aspect, driving each switching element includes controlling the switching operation of each of the switching elements in the nominal operation region such that a conductive noise is reduced or electro-magnetic compatibility (EMC) performance is improved.

In one implementation of the second aspect, driving each switching element so as to reduce the switching loss of the inverter includes driving each switching element in a DPWM (discontinuous PWM) scheme in which each switching element is disactivated during a predetermined period.

### BRIEF DESCRIPTION OF THE DRAWINGS

FIG. 1 is a block diagram of a power converting device according to a first embodiment of the present disclosure.
FIG. 2 is a graph showing a resistance value according to a temperature of a NTC thermistor.
FIG. 3 is a graph showing a switching loss when a gate resistance value is fixed.
FIG. 4 is a graph showing a switching loss when the gate resistance value varies according to one embodiment of the present disclosure.
FIG. 5 is a flowchart showing a control method of a power converting device according to one embodiment of the present disclosure.
FIG. 6 and FIG. 7 are signal diagrams showing SVPWM and DPWM schemes, respectively.
FIG. 8 and FIG. 9 are graphs showing situations where a conductive noise is reduced.
FIG. 10 is a graph showing an effect of temperature reduction resulting from suppression of the switching loss of a switching element.
FIG. 11 is a circuit diagram showing main components of a power converting device of the present disclosure according to a second embodiment.
FIG. 12 is a circuit diagram showing main components of a power converting device according to a third embodiment of the present disclosure

### DESCRIPTION OF SPECIFIC EMBODIMENTS

For simplicity and clarity of illustration, elements in the figures are not necessarily drawn to scale. The same reference numbers in different figures denote the same or similar elements, and as such perform similar functionality.

Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure.

Examples of various embodiments are illustrated and described further below. It will be understood that the description herein is not intended to limit the claims to the specific embodiments described. On the contrary, it is intended to cover alternatives, modifications, and equivalents as may be included within the spirit and scope of the present disclosure as defined by the appended claims.

The terminology used herein is for the purpose of describing particular embodiments only and is not intended to be limiting of the present disclosure. As used herein, the singular forms "a" and "an" are intended to include the plural forms as well, unless the context clearly indicates otherwise. It will be further understood that the terms "comprises", "comprising", "includes", and "including" when used in this specification, specify the presence of the stated features, integers, operations, elements, and/or components, but do not preclude the presence or addition of one or more other features, integers, operations, elements, components, and/or portions thereof. As used herein, the term "and/or" includes any and all combinations of one or more of the associated listed items. Expression such as "at least one of' when preceding a list of elements may modify the entire list of elements and may not modify the individual elements of the list.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the spirit and scope of the present disclosure.

In addition, it will also be understood that when a first element or layer is referred to as being present "on" a second element or layer, the first element may be disposed directly on the second element or may be disposed indirectly on the second element with a third element or layer being disposed between the first and second elements or layers.

It will be understood that when an element or layer is referred to as being "connected to", or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

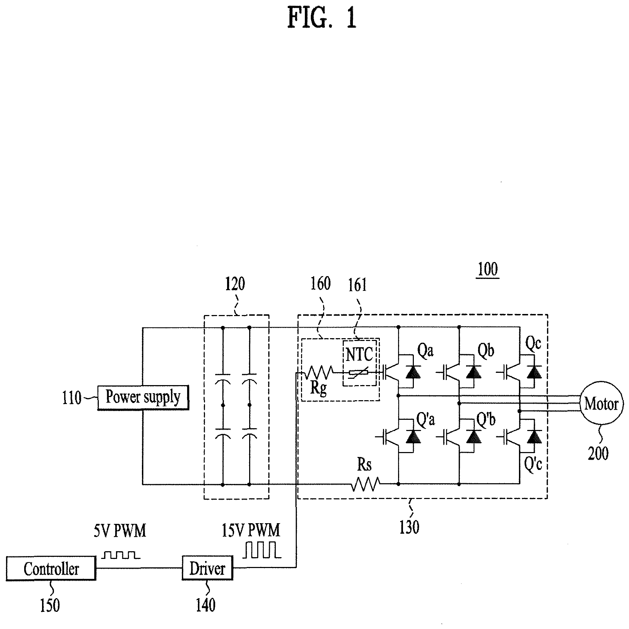

FIG. 1 is a block diagram of a power converting device according to a first embodiment of the present disclosure.

Referring to FIG. 1, a power converting device 100 for driving a motor 200 includes an inverter 130 including a plurality of switching elements Qa, Qb, Qc, Q'a, Q'b, and Q'c to generate an alternate current for driving the motor 200 using power supplied from a power supply 110.

The inverter 130 has the plurality of switching elements Qa, Qb, Qc, Q'a, Q'b and Q'c. On/off operations of the switching elements converts a direct current power from the power supply 110 into a three-phase alternate current power of a predetermined frequency. Then, the inverter may output the three-phase alternate current power to the motor 200.

Specifically, the inverter 130 may be configured such that the upper switching elements Qa, Qb, and Qc are respectively paired with and are serially connected to the lower switching elements Q'a, Q'b, and Q'c to form a total of three pairs of upper and lower switching elements which are connected to each other in parallel.

Each of the switching elements Qa, Qb, Qc, Q'a, Q'b, and Q'c of the inverter 130 may be embodied as a power transistor, for example, as an insulated gate bipolar mode transistor (IGBT).

In this connection, the power supply 110 may act as a power source for supplying direct current (DC) power. For example, the power supply may be a battery for an automobile.

In some embodiments, the power supply 110 may include a rectifier (not shown) for rectifying the alternate current power to DC power. In this connection, the power supply 110 may further include a converter (not shown) to boost/reduce or rectify the rectified DC voltage from the rectifier.

Further, the power converting device 100 includes a driver 140 for driving the plurality of switching elements Qa, Qb, Qc, Q'a, Q'b and Q'c, and a controller 150 for transmitting a drive signal to the driver 140.

The controller 150 may output an inverter control signal to the inverter 130 to control the switching operation of the inverter 130. The inverter control signal may include a switching control signal for pulse width modulation (PWM). This signal may be generated and output based on an output current flowing to the motor 200 and the voltage of the power supply 110.

That is, the on/off signals applied to the switching elements Qa, Qb, Qc, Q'a, Q'b and Q'c may include PWM signals (for example, 5V PWM) corresponding to six channels (for 3 phases AC), which may be outputted from the controller 150 to the driver 140.

The driver 140 may amplify the PWM signals to signals (15V PWM) capable of driving the switching elements Qa, Qb, Qc, Q'a, Q'b and Q'c. The amplified signals may be applied to the gate terminals of the switching element Qa, Qb, Qc, Q'a, Q'b and Q'c. In this connection, a gate resistor having a resistance value varying based on a temperature of the inverter 130 (or the switching element 160) may be disposed between the driver 140 and the gate terminal of each of the switching elements Qa, Qb, Qc, Q'a, Q'b and Q'c.

In one example, a ripple remover 120 may be provided between the power supply 110 and the inverter 130. As shown in the figure, the ripple remover 120 may have a plurality of capacitors connected in series/parallel.

This ripple remover 120 may remove the voltage ripple between the power supply 110 and the inverter 130, and thus may remove harmonic current ripple.

FIG. 1 shows a variable resistance unit 160 connected to a gate terminal of one switching element Qa. However, the present disclosure is not limited thereto. Each variable resistance unit 160 may be disposed between the driver 140 and each of the switching elements Qa, Qb, Qc, Q'a, Q'b, and Q'c.

As shown, the variable resistance unit 160 may include an NTC (Negative Temperature Coefficient) thermistor 161 having a resistance value inversely proportional to a temperature.

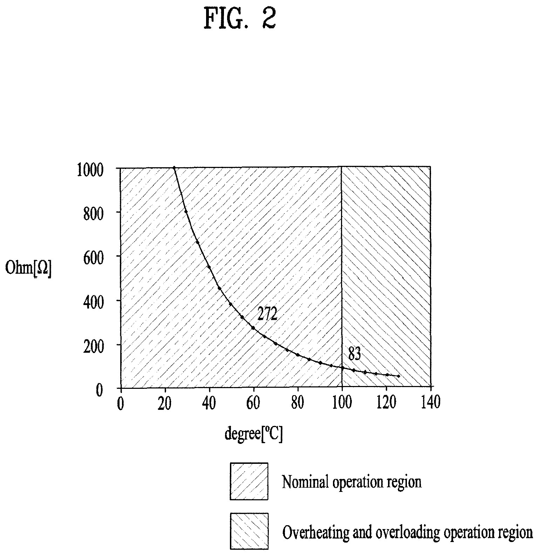

FIG. 2 is a graph showing a resistance value according to the temperature of the NTC thermistor.

As shown in FIG. 2, the NTC thermistor 161 has a resistance value that is inversely proportional to the temperature, and thus may have a function of measuring the temperature. Further, since the voltage based on the resistance value in inverse proportion to the temperature is applied across the NTC thermistor 161, the output voltage therefrom is inversely proportional to the temperature.

Hereinafter, the NTC thermistor 161 having the resistance value in inverse proportion to the temperature will be simply referred to as a thermistor 161.

Referring back to FIG. 1, the variable resistance unit 160 may further include a gate resistor Rg in series with the thermistor 161. That is, the variable resistance unit 160 may have combination of resistance values of the thermistor 161 and the gate resistor Rg.

Since the thermistor 161 is installed in the inverter 130, the variable resistance unit 160 may have a gate resistance value that varies depending on the temperature of the inverter 130.

The details of controlling the power converting device 100 by the controller 150 using the variable resistance unit 160 having a variable gate resistance value based on the temperature of the inverter 130 will be described in detail below.

In one example, the motor 200 may be a compressor motor that drives the compressor. Hereinafter, an example in which the motor 200 is a compressor motor, and the power converting device 100 is a motor driving device that drives such a compressor motor will be set forth.

However, the motor 200 is not limited to a compressor motor and may be applied to AC motors of various applications using frequency-variable AC voltages, for example, refrigerators, washing machines, electric trains, automobiles, and vacuum cleaners.

As described above, the variable resistance unit 160 may have a gate resistance value that varies depending on the temperature of the inverter 130 or the switching element.

In this connection, the controller 150 senses the resistance value of the variable resistance unit 160 and changes the switching operation of the switching elements Qa, Qb, Qc, Q'a, Q'b and Q'c according to the resistance value of the variable resistance unit 160. Hereinafter, for convenience of explanation, the case of controlling the upper switching element Qa of the first phase (for example, U phase) will be described by way of example. However, it goes without saying that the following description may be applied to all other switching elements Qb, Qc, Q'a, Q'b and Q'c.

The controller 150 may divide the operation region into a nominal operation region and an overheating operation region based on the resistance value of the variable resistance unit 160 and then adjust the switching operation of the switching element Qa based on the nominal operation region and overheating operation region.

That is, the combination of using the variable resistance unit 160 whose resistance value changes according to the temperature, and measuring the resistance value of the variable resistance unit 160 or the voltage across the variable resistance unit 160 by the controller 150 may allow the temperature of the inverter 130 or the switching element to be measured without a separate temperature sensor. The switching operation of the switching element Qa may be controlled according to the measured temperature of the inverter 130 or the switching element.

For example, the nominal operation region in FIG. 2 may correspond to a temperature range below 100 °C. The overheating operation region in FIG. 2, or the overloading and overheating operation region in FIG. 2 may correspond to a temperature range exceeding 100 °C.

In one embodiment, the resistance value of the variable resistance unit 160 in the nominal operation region decreases over the increasing temperature. That is, the gate resistance value of the variable resistance unit 160 connected to the switching element Qa decreases as the temperature of the inverter 130 rises.

Accordingly, the controller 150 may drive the switching element Qa using the gate resistance value that decreases as the temperature of the inverter 130 increases.

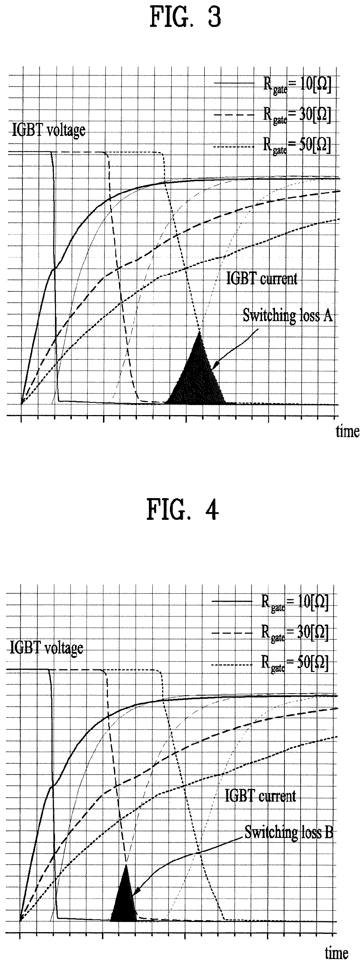

FIG. 3 is a graph showing the switching loss when the gate resistance value is fixed. Further, FIG. 4 is a graph showing the switching loss when the gate resistance value varies according to one embodiment of the present disclosure.

Referring to FIG. 3 and FIG. 4, one example in which the switching element Qa has the constant internal temperature will be set forth.

That is, referring to FIG. 3, for example, when the internal temperature of the switching element Qa is about 140 °C and the gate resistance value is 50Ω, a switching loss corresponding to an area A occurs.

In FIG. 3 and FIG. 4, a falling line over time on the left refers to the voltage of the switching element (IGBT; Qa); and a rising line over time on the right side indicates current of the switching element (IGBT; Qa). In this connection, the overlapping region between the voltage and the current corresponds to the switching loss.

To the contrary, referring to FIG. 4, when the variable resistance unit 160 with a gate resistance value that varies based on the temperature is applied in accordance with the present disclosure, and when the internal temperature of the switching element Qa is about 140 °C, the gate resistor may be reduced to about 30Ω, and, therefore, the switching loss may be reduced to the area B.

In this connection, the internal temperature of the switching element Qa may be reduced to about 128 degrees C as the switching loss is reduced in the case of FIG. 4.

As such, when the variable resistance unit 160 having the gate resistance value varying according to temperature is applied, and the switching element Qa is controlled using the variable resistance unit 160, this may reduce the switching loss. Therefore, the internal temperature of the switching element Qa can be lowered.

That is, in the overloading of the inverter 130 and the overheating operation thereof due to external temperature, the resistance value of the variable resistance unit 160 connected to the gate stage of the switching element Qa is lowered, such that the switching loss can be lowed and the heating value from the switching element Qa can be reduced.

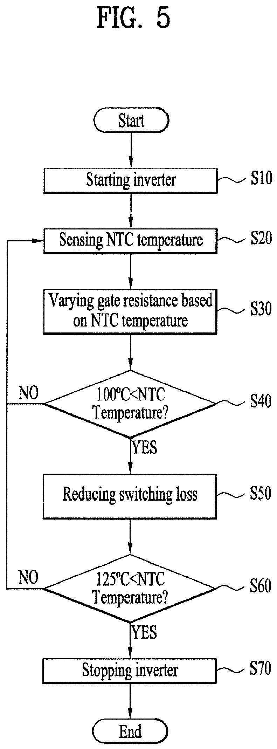

FIG. 5 is a flowchart showing the control method of the power converting device according to one embodiment of the present disclosure.

Hereinafter, the control operation by the controller 150 according to one embodiment of the present disclosure is described in detail with reference to FIG. 1 and FIG. 5.

Referring to FIG. 5, first, the controller 150 transmits a control signal to the driver 140 to start the inverter 130 (S10).

Then, the controller 150 senses the temperature via the thermistor 161 included in the variable resistance unit 160 (S20).

In this connection, the resistance value of the variable resistance unit 160 varies depending on the temperature sensed by the thermistor 161. That is, the resistance value of the thermistor 161 varies depending on the temperature. Thus, the resistance value of the variable resistance unit 160, that is, the gate resistance value connected to the gate stage of the switching element Qa varies based on the temperature (S30).

The controller 150 then controls the inverter 130 according to the resistance value of the variable resistance unit 160.

That is, in the nominal operating region, for example, in a temperature range below 100 °C, the resistance value of the variable resistance unit 160 decreases as the temperature of the inverter 130 or the switching element Qa rises. As a result, the switching loss is reduced. Thus, the temperature rise of the inverter 130, or the switching element Qa can be suppressed.

In this connection, the nominal operation region may be defined as a temperature range below a first setting temperature. The overheating operation region may be defined as the temperature range above the first setting temperature.

However, the overheating operation region, for example, the temperature range above 100 °C may require additional controlling operations. This is because, in the overheating operation region, it may not be sufficient to suppress the temperature rise of the inverter 130 or the switching element Qa via the reduction of the switching loss by the variable resistance unit 160.

Thus, additional switching loss reduction operations may be performed in the overheating operation region.

This additional switching loss reduction operation may include an operation to drop the switching frequency. For example, the switching frequency may be lowered by about 20%. When a switching waveform is applied to the inverter at a frequency of 10 kHz, the frequency of the switching waveform may be reduced to 8 kHz in this overheating operation region.

Further, the additional switching loss reduction operation may include an operation that performs a DPWM (discontinuous PWM) scheme in which the switching element Qa is not activated during the certain period.

This means that in the nominal operation region, the switching element Qa is driven in the SVPWM (space vector PWM) scheme rather than in the DPWM scheme.

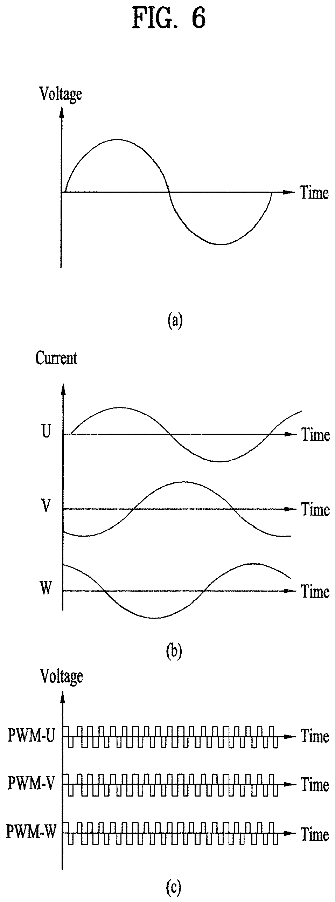

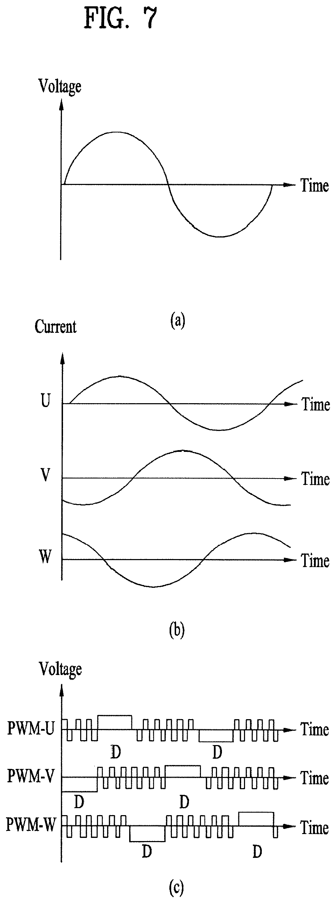

FIG. 6 and FIG. 7 show the SVPWM and DPWM schemes, respectively. In FIG. 6 and FIG. 7, (a) represents the reverse electromotive force waveform, and (b) represents the three-phases (U, V, W) current waveforms, and (c) represents the PWM signal.

As shown in (c) in FIG. 7, the PWM signal includes region D, in which, according to the DPWM scheme, the switching element Qa is not activated during the certain period.

Thus, the switching loss may be further reduced due to the region D in which the switching element Qa is not driven during the certain period, thereby further suppressing the temperature rise of the inverter 130 or the switching element Qa.

However, since the DPWM scheme may generate relatively noises, the switching element Qa may be driven in the SVPWM scheme instead of the DPWM scheme in the nominal operation region.

In this connection, the controller 150 may perform an operation to reduce conducive noise or to improve EMC (Electro-Magnetic Compatibility) performance in the nominal operation region.

That is, as the temperature of the switching element Qa rises, the resistance value of the variable resistance unit 160 decreases. As a result, the conductive noise can be reduced.

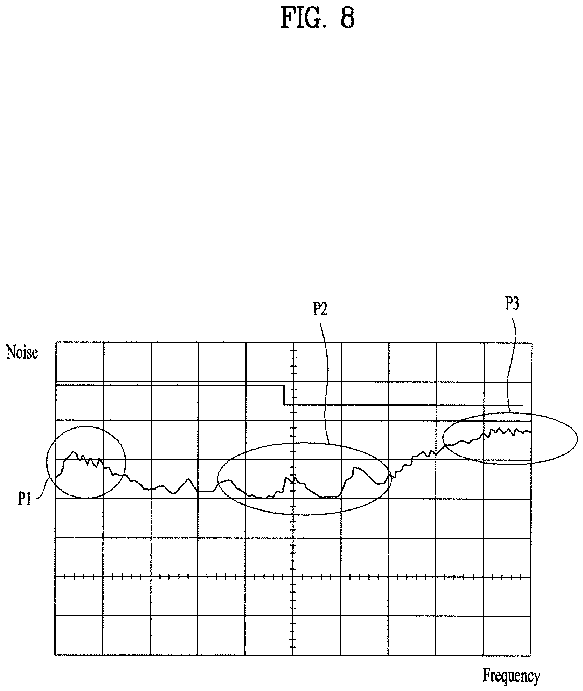

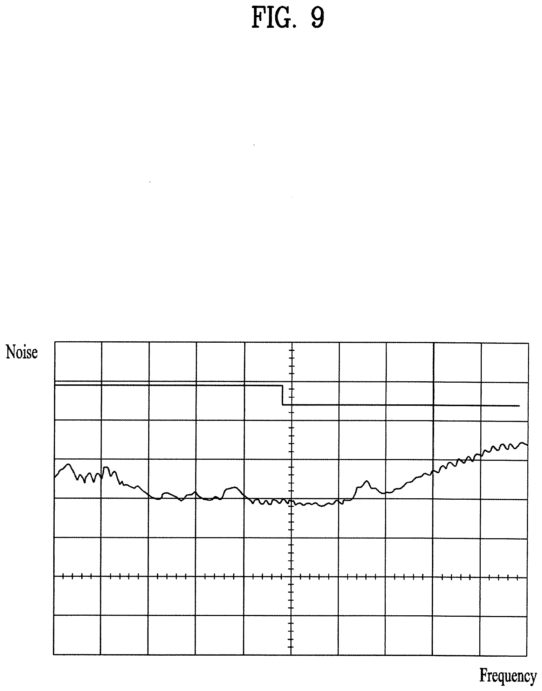

FIG. 8 and FIG. 9 are graphs showing situations where the conductive noise is reduced.

In FIG. 8 and FIG. 9, a horizontal axis refers to the frequency band and a vertical axis refers to the noise magnitude.

When comparing the noise measurement waveforms of FIG. 8 and FIG. 9 with each other, peak components PI, P2, and P3 appearing in a specific frequency band in FIG. 8 do not appear in FIG. 9.

The noise components of the inverter 150 may increase due to the voltage/current generated when the switching element Qa switches.

In particular, the overshoot voltage/current caused by the parasitic parameters of the switching element Qa can affect the noise.

A formula related to this overshoot is "L * (di / dt) = overshoot voltage". In this connection, the higher the gate resistor, the longer the dt, that is, the switching time. Thus, the overshoot voltage may be lowered.

Referring back to FIG. 5, the controller 150 stops the driving of the inverter 130 when the temperature sensed from the gate resistor exceeds the temperature of the overheating operation region, for example, when the temperature exceeds 125 degrees C.

A temperature region in which the temperature exceeds the temperature of this overheating operation region may be referred to as a temperature range that exceeds a second setting temperature.

As described above, when the switching element Qa or the inverter 130 exceeds a certain temperature, the driving of the inverter 130 may be stopped and the inverter 130 can be protected.

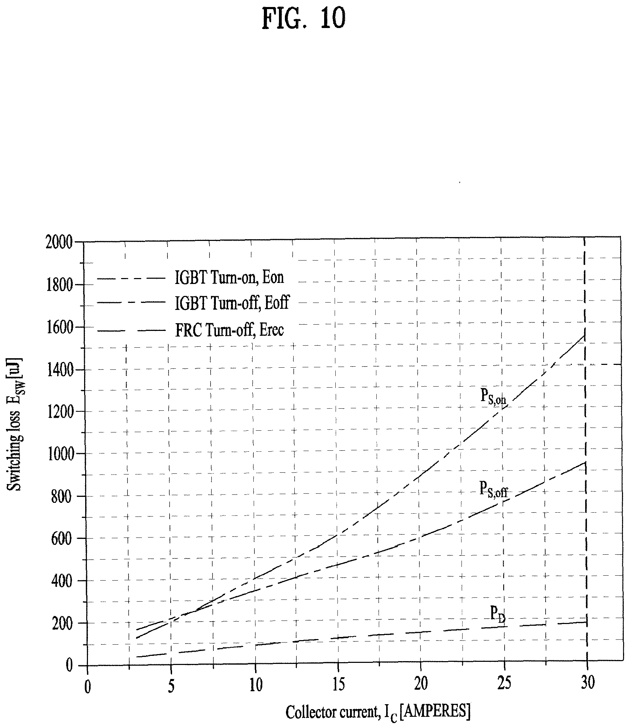

FIG. 10 is a graph showing the effect of temperature reduction based on the lowering of the switching loss of the switching element.

FIG. 10 shows a case where a case temperature of the switching element (IGBT; Qa) is 100 degrees C, and current applied to the switching element Qa is 30A.

Referring to FIG. 10, a turn on loss P_{S,on} of the switching element Qa is 1580µJ × fs (switching frequency), which corresponds to 15.8W. Further, Ps,off, which is a turn off loss of the switching element Qa corresponds to 9.8 W, which is 980 µJ × fs (switching frequency). In this connection, the total switching loss P_{S,total} (not shown) of the switching element Qa is 25.6W.

In this connection, the junction temperature Tj of the switching element Qa may be calculated as "(Ps, total + Rth(j-c)Q) + (PD + Rth(j-c)F) + Tc". Thus, Tj may be calculated as "(25.6 × 1.4) + (2 × 2.4) + Tc" and thus may be 140.6 ° C.

In this connection, Rth(j-c)Q refers to a thermal resistance coefficient between the junction and case of the switching element Qa. Rth(j-c)F refers to a thermal resistance coefficient between the junction and case of an anti-parallel diode. Further, P_{D} refers to the loss of the antiparallel diode. Tc indicates the case temperature of the switching element Qa.

In this connection, the junction temperature Tj of the switching element Qa may be calculated as follows when the switching loss is lowered by 30%: Tj is calculated as "(17 x 1.4) + (2 x 2.4) + Tc" and is calculated to be 128.6 degrees C. Thus, it may be seen that the internal temperature of the switching element Qa may be lowered by about 12 ° C.

That is, the junction temperature is based on the sum of the losses occurring in the switching element Qa and the case temperature Tc of the switching element Qa.

In this connection, the losses occurring in the switching element Qa may be roughly divided into a switching loss, a conduction loss, and a diode loss.

According to the present disclosure, the junction temperature of the switching element may be lowered by suppressing the switching loss occurring in the switching element Qa.

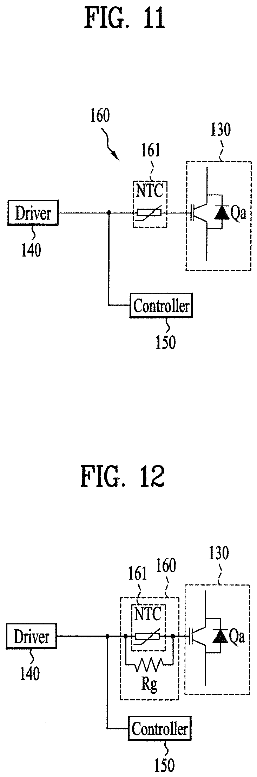

FIG. 11 is a circuit diagram showing main components of the power converting device according to a second embodiment of the present disclosure. FIG. 12 is a circuit diagram showing main components of the power converting device according to a third embodiment of the present disclosure.

Referring to FIG. 11, an embodiment in which the variable resistance unit 160 is constituted only by the thermistor 161 is shown. In this connection, the resistance value of variable resistance unit 160 may only be determined by the thermistor 161.

Further, referring to FIG. 12, it may be seen that the variable resistance unit 160 is composed of a parallel connection between the thermistor 161 and the gate resistor Rg. In this connection, the resistance value of the variable resistance unit 160 may be determined by the combination of the resistance values of the thermistor 161 and the gate resistor Rg in the parallel manner.

The descriptions of the first embodiment as described above may be equally applied to the second and third embodiments. Overlapping descriptions therebetween are omitted.

According to the present disclosure, the damage to the switching element due to the overheating of the inverter 130 may be suppressed. Thus, it is possible to extend the lifetime of the switching element. Further, EMC performance can be improved in the nominal operation section.

That is, according to the present disclosure, the inverter temperature may be monitored via the voltage of NTC thermistor. Thus, it is possible to implement additional operations depending on the temperature.

Accordingly, the on/off switching rate of the switching element may be actively changed according to the inverter temperature via the NTC thermistor.

As a result, the switching element of the inverter may be automatically controlled without a separate controller and additional active components.

The embodiments of the present disclosure as disclosed in the present specification and drawings are merely illustrative of specific examples for purposes of understanding of the present disclosure, and, thus, are not intended to limit the scope of the present disclosure. It will be apparent to those skilled in the art that other variations based on the technical idea of the present disclosure other than the embodiments disclosed herein are feasible.

## Claims

1. A power converting device for driving a compressor motor, the device comprising:
an inverter for generating an alternate current for driving the motor using power supplied from a power supply, the inverter including a plurality of switching elements;
a driver for driving the plurality of switching elements;
a variable resistance unit disposed between and electrically coupled to the driver and a gate of each of the switching elements, wherein the variable resistance unit has a resistance value varying based on a temperature of the inverter; and
a controller configured for transferring a drive signal to the driver.

2. The power converting device of claim 1, wherein the variable resistance unit includes a thermistor having a resistance value inversely proportional to a temperature.

3. The power converting device of claim 2, wherein the variable resistance unit further includes a gate resistor connected in series or in parallel with the thermistor.

4. The power converting device of any of claims 1 to 3, wherein the controller is configured for:
sensing a resistance value of the variable resistance unit; and
controlling a switching operation of each of the switching elements based on the sensed resistance value of the variable resistance unit.

5. The power converting device of claim 4, wherein the controller is further configured for:
classifying an operation region of the inverter into a nominal operation region and an overheating operation region based on the resistance value of the variable resistance unit; and
controlling a switching operation of each of the switching elements based on the nominal operation region or the overheating operation region.

6. The power converting device of claim 5, wherein the controller is further configured for controlling the switching operation of each of the switching elements in the overheating operation region such that each switching element operates in a discontinuous PWM (DPWN) scheme in which each switching element is disactivated during a predetermined period.

7. The power converting device of claim 5 or 6, wherein the controller is further configured for controlling the switching operation of each of the switching elements in the nominal operation region such that a conductive noise is reduced or electro-magnetic compatibility (EMC) performance is improved.

8. The power converting device of any of claims 5 to 7, wherein the controller is further configured for stopping an operation of the inverter when a temperature sensed from the variable resistance unit exceeds a temperature of the overheating operation region.

9. The power converting device of any of claims 5 to 8, wherein the controller is further configured for controlling the switching operation of each of the switching elements in the overheating operation region so as to reduce a switching loss of each of the switching elements.

10. A method for operating a power converting device,
wherein the device includes an inverter for generating an alternate current for driving the motor using power supplied from a power supply, wherein the inverter includes a plurality of switching elements driven by a driver, and a variable resistance unit disposed between and electrically coupled to the driver and a gate of each of the switching elements, wherein the variable resistance unit has a resistance value varying based on a temperature of the inverter,
wherein the method comprises:
driving each switching element based on the resistance value of the variable resistance unit when a temperature of the inverter is equal to or lower than a first setting temperature; and
driving each switching element so as to reduce a switching loss of the inverter when the temperature of the inverter exceeds the first setting temperature.

11. The method of claim 10, wherein the method further comprises stopping an operation of the inverter when the temperature of the inverter exceeds a second setting temperature higher than the first setting temperature.

12. The method of claim 10 or 11, wherein driving each switching element so as to reduce the switching loss of the inverter includes lowering a switching frequency of each switching element.

13. The method of any of claims 10 to 12, wherein driving each switching element includes controlling the switching operation of each of the switching elements in the nominal operation region such that a conductive noise is reduced or electro-magnetic compatibility (EMC) performance is improved.

14. The method of any of claims 10 to 13, wherein driving each switching element so as to reduce the switching loss of the inverter includes driving each switching element in a DPWM (discontinuous PWM) scheme in which each switching element is disactivated during a predetermined period.
